(19) Europäisches Patentamt
European Patent Office
Office européen des brevets

(11) Publication number: **0 363 978 A2**

(12) # EUROPEAN PATENT APPLICATION

(21) Application number: 89119055.5

(51) Int. Cl.[5]: G03F 7/022

(22) Date of filing: 13.10.89

(30) Priority: 13.10.88 JP 258937/88

(43) Date of publication of application: 18.04.90 Bulletin 90/16

(84) Designated Contracting States: BE DE FR GB IT NL

(71) Applicant: SUMITOMO CHEMICAL COMPANY, LIMITED
Kitahama 4-chome 5-33
Chuo-ku Osaka 541(JP)

(72) Inventor: Uetani, Yasunori
4-9-17, Sakuragaoka
Minoo-shi Osaka-fu(JP)
Inventor: Hanabata, Makoto
1-147, Asahigaoka Inagawa-cho
Kawabe-gun Hyogo-ken(JP)
Inventor: Nakanishi, Hirotoshi
1-8-14, Yamazaki Shimamoto-cho
Mishima-gun Osaka-fu(JP)
Inventor: Kuwana, Koji
5-3-16, Hayashi
Fujiidera-shi Osaka-fu(JP)
Inventor: Oi, Fumio
3-1-506, Hamaashiya-cho
Ashiya-shi Hyogo-ken(JP)

(74) Representative: Vossius & Partner
Siebertstrasse 4 P.O. Box 86 07 67
D-8000 München 86(DE)

(54) **Resist composition.**

(57) Positive resist compositions which comprise an alkali-soluble resin and, as a sensitizer, a quinone diazide sulfonic acid ester of a phenol compound, wherein

(a) a peak area corresponding to the quinone diazide sulfonic acid diester of the phenol compound having not less than three hydroxyl groups is not less than 40 % of all peak areas corresponding to the sensitizers in a HPLC spectrum measured with a primary detector using IR light with the wavelength of 254 nm, and

(b) a peak area corresponding to the complete ester of the phenol compound having not less than two hydroxyl groups with the quinone diazide sulfonic acid is not less than 5 % and less than 60 % of all peak areas corresponding to the sensitizers in the HPLC spectrum, which compositions have high $\gamma$-values and a high film thickness retention.

EP 0 363 978 A2

## Resist Composition

The present invention relates to resist compositions which have high $\gamma$-values and a high film thickness retention.

Compositions containing a compound having a quinone diazide group such as a naphthoquinone diazide group or a benzoquinone diazide group and an alkali-soluble resin already finds use as positive resists, because upon exposure to ultraviolet rays, the quinone diazide group decomposes to form a carboxyl group whereby the originally alkali-insoluble compositions becomes alkali-soluble. A condensation product of a phenol compound (e.g. trihydroxybenzophenone or tetrahydroxybenzophenone) with a quinone diazide compound is used as a sensitizer.

However, particularly in the field of integrated circuits, miniaturization has proceeded with a rise of the integration level, which results in demands for the formation of patterns of submicron order with sufficient resolution (high $\gamma$-value). As a result, the conventional compositions cannot render the desired $\gamma$-values.

For example, if the amount of quinone diazide groups is increased to improve the $\gamma$-value, serious problems such as deterioration of sensitivity and increase of residues after developing arise.

Therefore, the improvement of the $\gamma$-value is limited.

To achieve better resolution, high film thickness retention as well as the high $\gamma$-value is desired.

One object of the present invention is to provide positive resist compositions which have high $\gamma$-values and a high film thickness retention.

Another object of the present invention is to provide a sensitizer which comprises a quinone diazide sulfonic acid ester of a phenol compound and is used in positive resist compositions.

The present invention is based on the finding that, when a sensitizer comprises largely a diester of a phenol compound having not less than three hydroxyl groups with a quinone diazide sulfonic acid and a complete ester of a phenol compound having not less than two hydroxyl groups with a quinone diazide sulfonic acid, the positive resist compositions comprising such sensitizers have high $\gamma$-values and a good film thickness retention.

Accordingly, the present invention provides positive resist compositions which comprise an alkali-soluble resin and, as a sensitizer, a quinone diazide sulfonic acid ester of a phenol compound, wherein

(a) the peak area corresponding to the quinone diazide sulfonic acid diester of the phenol compound having not less than three hydroxyl groups is not less than 40 % of all peak areas corresponding to the sensitizers in a HPLC spectrum measured with a primary detector using IR light having the wavelength of 254 nm, and

(b) a peak area corresponding to the complete ester of the phenol compound having not less than two hydroxyl groups with the quinone diazide sulfonic acid is not less than 5 % and less than 60 % of all peak areas corresponding to the sensitizer in the HPLC spectrum.

In the present invention, the HPLC measurement is carried out under such conditions that peaks for two or more components do not overlap each other. If peaks overlap each other, analysis conditions such as the composition of the mobile phase should be optimized. In no case, the wavelength of 254 nm of the primary detector should be changed.

The peak area corresponding to the diester is preferably not less than 50 %. That is, preferably, the peak area corresponding to the complete ester is less than 50 %.

The quinone diazide sulfonic acid esters of the phenol compounds may be prepared by a per se conventional method. For example, the esters are prepared by a condensation reaction of the phenol compound with naphthoquinone diazide sulfonyl halogenide or benzoquinone diazide sulfonyl halogenide in the presence of a weak alkali such as sodium carbonate.

There are various processes to prepare the quinone diazide sulfonic acid diester.

For example, the diester component is preferentially prepared from the following phenol compounds are used as the phenol compounds having not less than three hydroxyl groups:

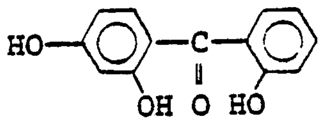

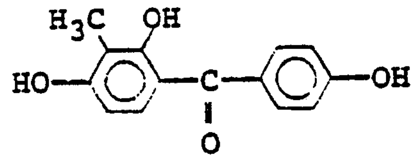

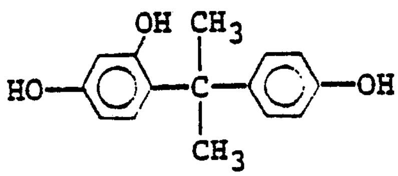

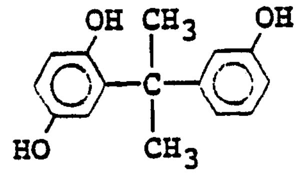

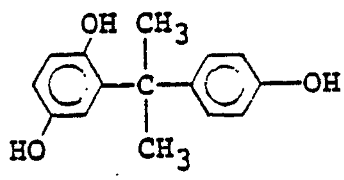

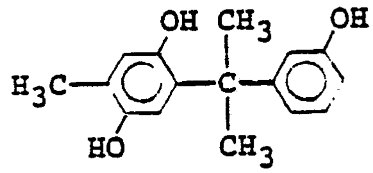

or

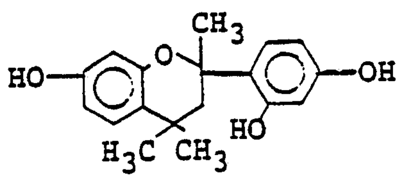

In another process, chloroform is used as a solvent in the condensation reaction of a quinone diazide sulfonyl halogenide with the phenol compound to preferentially obtain the quinone diazide sulfonic acid diester. Examples of other solvents which have the same effects as chloroform are trichloroethane, trichloroethylene or dichloroethane.

The positive resist compositions of the present invention may contain two or more quinone diazide sulfonic acid esters of the phenol compound in combination. In the case, when the peak area corresponding to the complete ester of the phenol compound having not less than two hydroxyl groups with quinone diazide sulfonic acid is less than 5 % of all the peak areas, an ester which comprises the complete ester in a larger amount should be added.

The ester which comprises the complete ester in a larger amount is prepared by reacting at least "m-1" equivalents of the quinone diazide compound with "m" equivalents of the hydroxyl groups of the phenol compound.

A typical example of the di- or polyhydric phenol compound is represented by the general formula (I):

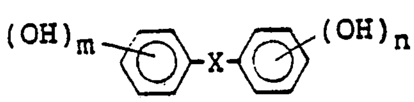

(I)

wherein X is a group of the formula:

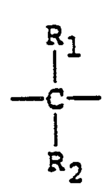

or

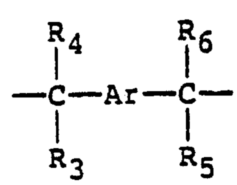

;

in which $R_1$, $R_2$, $R_3$, $R_4$, $R_5$ and $R_6$ are the same or different and each may represent a hydrogen atom, a $C_{1-8}$-alkyl group, preferably a $C_{1-4}$-alkyl group, a $C_{6-18}$-aryl group, preferably a $C_{6-14}$-aryl group, more preferably a $C_{6-12}$-aryl group, a $C_{2-8}$-alkenyl group, preferably a $C_{2-5}$-alkenyl group, or a cyclohexyl group and Ar is a divalent aromatic group with 6 to 18, preferably 6 to 14, more preferably 6 to 12 carbon

atoms; m and n are the same or different and each is zero or a positive number, provided that the sum of m and n is not less than 2 and not more than 6, preferably not more than 4 and more preferably not more than 3.

Examples of the other di- or polyhydric phenol compounds are hydroquinone, resorcinol, phloroglucin, 2,4-dihydroxybenzophenone, 2,3,4-trihydroxybenzophenone, tetrahydroxybenzophenones such as 2,3,3',4-tetrahydroxybenzophenone, 2,3,4,4'-tetrahydroxybenzophenone and 2,2',4,4'-tetrahydroxybenzophenone, pentahydroxybenzophenones such as 2,3,3',4,4'-pentahydroxybenzophenone and 2,3,3',4,5'-pentahydroxybenzophenone, $C_{1-8}$-alkyl gallates, preferably $C_{1-4}$-alkyl gallates or oxyflavans.

A novolak resin is preferably used as the alkali-soluble resin. The novolak resins are prepared by a condensation reaction of a phenol with formaldehyde. Specific examples of the phenols used as starting materials for the novolak resins include phenol, cresols, xylenol, ethylphenol, trimethylphenol, propylphenol, butylphenol, dihydroxybenzene or naphthols. These phenols may be used alone or in combination.

The formaldehyde which undergoes the condensation reaction with the phenols can be used in the form of an aqueous solution of formaldehyde (formalin) or paraformaldehyde which is an oligomer of formaldehyde. Particularly, 37 % formalin which is a commercially mass product is suitably used.

The condensation reaction of the phenols with formaldehyde can be carried out according to the usual methods. This reaction is carried out at a temperature of 60 to 120 °C for 2 to 30 hours. Organic acids, inorganic acids or divalent metal salts are used as catalysts. Specifically, exemplified are oxalic acid, hydrochloric acid, sulfuric acid, perchloric acid, p-toluenesulfonic acid, trichloroacetic acid, phosphoric acid, formic acid, zinc acetate or magnesium acetate.

The reaction may be carried out in the presence or absence of a solvent.

The amount of the quinone diazide sulfonic acid ester to be added to the resist composition ranges from 10 to 50 % by weight based on the total weight of the solid components in the resist composition.

The positive photoresists are prepared by mixing and dissolving the above-mentioned quinone diazide ester and the novolak resin in a solvent. Preferably, the used solvent evaporates at a suitable drying rate to give a uniform and smooth coating film. Such solvents include ethylcellosolve acetate, methylcellosolve acetate, ethylcellosolve, methylcellosolve, propylene glycol, monomethyl ether acetate, butyl acetate, methyl isobutyl ketone or xylene.

To the positive photoresist compositions obtained by the above-mentioned method, small amounts of resins or dyes may be added if desired.

With the resist compositions of the present invention, the γ-values and the film thickness retention can be improved and the problems associated with increase of developing remains can be solved.

The present invention will be illustrated more in detail with the following Examples, but it is not limited to these Examples. In the Examples "parts" are by weight.

Synthesis Example 1

(Synthesis of the sensitizer A)

In a 300 ml three-necked flask, 6.00 g of the compound (I) obtained in Example 1 of JP-A-139375/1980, 10.75 g of naphthoquinone-(1,2)-diazide-(2)-5-sulfonyl chloride (in the molar ratio of 1:2) and 168 g of dioxane were charged and stirred to achieve complete dissolution. 4.45 Grams of triethylamine were added dropwise over 30 minutes while stirring on a water bath to keep the reaction temperature at 20-25 °C. The reaction was completed while stirring for 4 more hours at 20-25 °C. The reaction solution was then poured into deionized water, filtered and dried to obtain a sensitizer, which is referred to as sensitizer A.

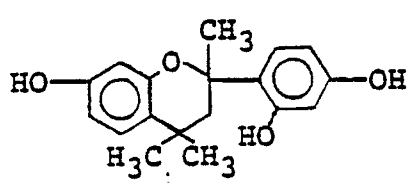

(I)

Synthesis Example 2-6

(Synthesis of the sensitizer B, C, D, E and F)

The same procedure as in Synthesis Example 1 was repeated, except that the compounds of the following formula (II) (for the sensitizer B), formula (III) (for the sensitizer C), formula (IV) (for the sensitizer D), formula (V) (for the sensitizer E) or 2,3,4-trihydroxybenzophenone (for the sensitizer F) (in the molar ratio of 1 : 2) were used instead of the compound (I) to obtain a sensitizer, which is referred to as sensitizer B, C, D, E or F.

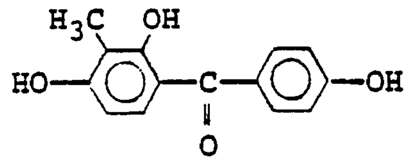

(II)

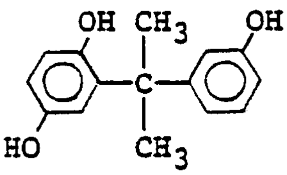

(III)

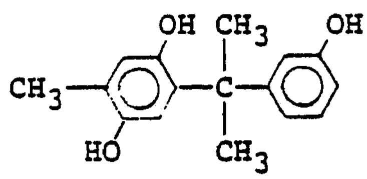

(IV)

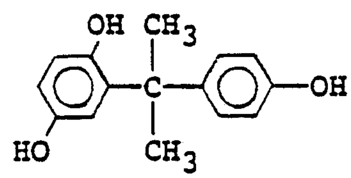

(V)

Synthesis Example 7

(Synthesis of the sensitizer G)

In a 300 ml three-necked flask, 4.60 g of 2,3,4-trihydroxybenzophenone, 10.75 g of naphthoquinone-(1,2)- diazide-(2)-5-sulfonyl chloride (in the molar ratio of 1:2) and 155 g of chloroform were charged and stirred to achieve complete dissolution. 4.45 Grams of triethylamine was added dropwise over 30 minutes while stirring on a water bath to keep the reaction temperature at 20-25 °C. The reaction was completed while stirring for 4 more hours at 20-25 °C. The reaction solution was then poured into deionized water, filtered and dried to obtain a sensitizer, which is referred to as sensitizer G.

Synthesis Example 8

(Synthesis of the sensitizer H)

The same procedure as in Synthesis Example 7 was repeated, except that the compound of the formula (II) was used instead of 2,3,4-trihydroxybenzophenone to obtain a sensitizer, which is referred to as

sensitizer H.

Synthesis Example 9-10

(Synthesis of the sensitizer I and J)

The same procedure as in Synthesis Example 7 was repeated, except that the compound (I) (for the sensitizer I) or 2,3,4,4′-tetrahydroxybenzophenone (for the sensitizer J) (on molar ratio of 1:3) was used instead of 2,3,4-trihydroxybenzophenone to obtain a sensitizer, which is referred to as sensitizer I or J.

Synthesis Example 11

(Synthesis of the sensitizer K)

The same procedure as in Synthesis Example 1 was repeated, except that the compound of the below described formula (VI) (in molar ratio of 1:4) was used instead of the compound (I), to obtain a sensitizer, which is referred to as sensitizer K.

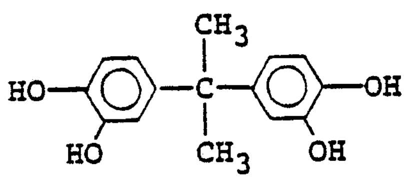

(VI)

Examples 1-9 and Comparative Examples 1-4

The sensitizer A through I obtained in Synthesis Examples 1-5 and a novolak resin in amounts shown in Table 1 were dissolved in 48 parts of ethyl cellosolve acetate to prepare resist solutions,which were filtered through a Teflon (trade mark) filter of 0.2 µm in pore size. The resist solution was used to coat a silicon wafer, which had been rinsed in a usual manner, by means of a spinner so as to form a resist film of 1.3 um in thickness. Subsequently, the silicon wafer was baked for 60 seconds on a hot plate kept at 100° C, and exposed to light while varying the exposure value stepwise by means of a reduction projection exposing apparatus (DSW 4800 with NA = 0.28 manufactured by GCA) with a wavelength of 436 nm. Thereafter, the silicon wafer was developed for 1 minute in a developing solution (SOPD manufactured by Sumitomo Chemical Company, Limited) to obtain a positive pattern. The $\gamma$-value is expressed in terms of tan $\theta$. The angle $\theta$ is obtained by plotting the rate of the standardized film thickness (= the retained film thickness/the original film thickness) against the exposure value and calculating the inclination of the plotted line. The $\gamma$-value and the resolution which was obtained at the same time are shown in the Table.

For the HPLC analysis, a chromatographic apparatus (LC-4A manufactured by Shimadzu Manufacturing, Limited) was used. As a column, Ricrosolve RP-10 (10 µm) (4 mm$\phi$ x 250 mm column manufactured by Sumika Chemical Analysis Service, Ltd.) and, as a carrier solvent, a mixture of 57.5 % of water, 36.1 % of Tetrahydrofuran (THF), 6.4 % of methanol and 1 % of formic acid were used. The flow rate of the carrier solvent was 1.0 ml/min.

A chromatographic analysis was carried out by using the primary detector with the IR light having the wavelength of 254 nm.

To identify the peaks corresponding to the diester component and the complete ester component, mass spectrometric analysis was carried out by a secondary ion mass spectrum (SIMS) after separation by HPLC.

Table

| Example No. | Resist component | | | HPLC Area Ratio (%) | | γ-value | Film thickness retention (%) |
|---|---|---|---|---|---|---|---|
| | Novolak resin*1) (parts) | Sensitizer (parts) | | Diester Component | Complete Ester component | | |
| 1 | 17 | A,4 | K,1 | 75 | 11 | 3.8 | 99 |
| 2 | 17 | B,5 | — | 66 | 22 | 3.6 | 99 |
| 3 | 17 | C,4 | K,1 | 77 | 12 | 3.9 | 99 |
| 4 | 17 | C,4 | I,1 | 79 | 10 | 3.8 | 99 |
| 5 | 17 | D,4 | K,1 | 72 | 12 | 3.9 | 99 |
| 6 | 17 | E,4 | K,1 | 70 | 13 | 4.0 | 99 |
| 7 | 17 | E,4 | I,1 | 72 | 14 | 4.0 | 99 |
| 8 | 17 | G,5 | — | 56 | 39 | 2.8 | 98 |
| 9 | 17 | H,5 | — | 84 | 8 | 4.2 | 98 |
| Comp. 1 | 17 | F,5 | — | 33 | 59 | 2.3 | 99 |
| Comp. 2 | 17 | J,5 | — | 12 | 55 | 2.1 | 99 |
| Comp. 3 | 17 | A,5 | — | 93 | 0 | 4.0 | 95 |
| Comp. 4 | 17 | C,5 | — | 95 | 2 | 4.1 | 96 |

Note: *1) Novolak Resin
A cresol mixture (the molecular ration of m-isomer to p-isomer, 7/3) was reacted with formalin (the molar ratio of formalin to cresol, 1/0.8) using oxalic acid as a catalyst under reflux to obtain a novolak resin of 9800 in weight average molecular weight calculated as polystyrene.

## Claims

1. Positive resist compositions which comprise an alkali-soluble resin and, as a sensitizer, a quinone diazide sulfonic acid ester of a phenol compound, wherein

(a) a peak area corresponding to the quinone diazide sulfonic acid diester of the phenol compound having not less than three hydroxyl groups is not less than 40 % of all peak areas corresponding to the sensitizers in a HPLC spectrum measured with a primary detector using IR light having the wavelength of 254 nm, and

(b) a peak area corresponding to the complete ester of the phenol compound having not less than two hydroxyl groups with the quinone diazide sulfonic acid is not less than 5 % and less than 60 % of all

peak areas corresponding to the sensitizers in the HPLC spectrum.

2. The positive resist composition according to claim 1, wherein the peak area corresponding to the quinone diazide sulfonic acid diester of the phenol compound having not less than three hydroxyl groups is not less than 50 % of all the peak areas corresponding to the sensitizers in the HPLC spectrum.

3. The positive resist composition according to claim 1 and 2, wherein the amount of the quinone diazide sulfonic acid ester of the phenol compound is from 10 to 50 % by weight based on the total weight of the solid components in the resist composition.